# EUROPEAN PATENT SPECIFICATION

(11) **EP 4 220 961 B1**
(45) Date of publication and mention of the grant of the patent: **12.11.2025**
(21) Application number: 23158770.0
(22) Date of filing: 17.01.2023
(51) Int. Cl.: H03K 19/00

(54) **INTEGRATED CIRCUIT DEVICE AND CHIP DEVICE**
INTEGRIERTE SCHALTUNGSANORDNUNG UND CHIPANORDNUNG
DISPOSITIF DE CIRCUIT INTÉGRÉ ET DISPOSITIF DE PUCE

(30) Priority: 26.01.2022 US 202263303122 P; 13.12.2022 US 202218065165
(43) Date of publication of application: 02.08.2023
(62) Divisional of application: 23152097.4
(73) Proprietor: MediaTek Inc., Hsinchu City 30078 (TW)
(72) Inventor: LUNG, Bo-Ren, Hsinchu City (TW); YANG, Jen-Hang, Hsinchu City (TW)
(74) Representative: Wright, Howard Hugh Burnby

(56) References cited:
- KR-A- 20000 003 339
- US-A- 5 376 829
- US-A1- 2005 162 192

## Description

The disclosure relates to an integrated circuit, and, in particular, to an integrated circuit device and a chip device for decreasing area and power consumption.

### Description of the Related Art

Generally, an integrated circuit may include a plurality of components. However, each of the components may use an independent power source, or the selecting signal of an independent selecting module, increasing the area and power consumption of the integrated circuit. Therefore, how to decrease the area and power consumption of the integrated circuit has become an important issue. US 2005/0162192 shows at Figure 1 a mux having inverters 102, 103, and transmission gates 104, 105 that are controlled by complementary signals S and SB. KR 2000-0003339 shows at Figure 6 a multiplexing circuit in which inverters IV21, IV22 are connected via NMOS (NM2) and PMOS (PM2) pass transistors, respectively, to an inverter IV23. US 5,376,829 shows at Figure 1 a multiplexer in which inputs d0, d1 are connected via NMOS pass transistors 18, 20 to an inverter 24; an inverter 22 enables one or the other of the NMOS pass transistors 18, 20.

### SUMMARY

The invention is defined in independent claim 1. An aspect of the disclosure provides an integrated circuit device and a chip device, thereby decreasing the area and power consumption of the integrated circuit device.

An embodiment of the disclosure provides an integrated circuit device including a reference voltage channel, a first cell and a second cell. The reference voltage channel is configured to provide a first reference voltage and a second reference voltage. The first cell is coupled to the reference voltage channel, and is configured to receive the first reference voltage and the second reference voltage. The second cell is coupled to the reference voltage channel, and is configured to receive the first reference voltage and the second reference voltage.

An embodiment of the disclosure provides a chip device, which includes at least one above integrated circuit device.

According to a first aspect of the invention, an integrated circuit device, which includes a plurality of selecting modules and a selecting signal providing module. Each of the selecting modules is configured to receive a first input signal, a second input signal, a first selecting signal and a second selecting signal, and select the first input signal or the second input signal to generate an output signal according to a first selecting signal and a second selecting signal. The selecting signal providing module is configured to provide the first selecting signal and the second selecting signal.

According to a second aspect of the invention, an integrated circuit device, comprises: a plurality of selecting modules, wherein each of the plurality of selecting modules is configured to receive a first input signal, a second input signal, a first selecting signal and a second selecting signal, and select the first input signal or the second input signal to generate an output signal according to a first selecting signal and a second selecting signal; and a selecting signal providing module, configured to provide the first selecting signal and the second selecting signal.

Preferably, the first selecting signal and the second selecting signal are inverted.

The module advantageously comprises: an inverter, having an input terminal and an output terminal, wherein the input terminal of the inverter receives the first selecting signal, and the output terminal of the inverter outputs the second selecting signal.

Each of the plurality of selecting modules may comprise a multiplexer.

Each of the plurality of selecting modules comprises according to the invention: a first transistor, having a first terminal, a second terminal and a control terminal, wherein the first terminal of the first transistor receives a first reference voltage, and the control terminal of the first transistor receives the first input signal; a second transistor, having a first terminal, a second terminal and a control terminal, wherein the first terminal of the second transistor receives a second reference voltage, the second terminal of the second transistor is coupled to the second terminal of the first transistor, and the control terminal of the second transistor is coupled to the control terminal of the first transistor; a third transistor, having a first terminal, a second terminal and a control terminal, wherein the first terminal of the third transistor receives the first reference voltage, and the control terminal of the third transistor receives the second input signal; a fourth transistor, having a first terminal, a second terminal and a control terminal, wherein the first terminal of the fourth transistor receives the second reference voltage, the second terminal of the fourth transistor is coupled to the second terminal of the third transistor, and the control terminal of the fourth transistor is coupled to the control terminal of the third transistor; a fifth transistor, having a first terminal, a second terminal and a control terminal, wherein the first terminal of the fifth transistor is coupled to the second terminal of the first transistor, and the control terminal of the fifth transistor receives the first selecting signal; a sixth transistor, having a first terminal, a second terminal and a control terminal, wherein the first terminal of the sixth transistor is coupled to the second terminal of the fifth transistor, the second terminal of the sixth transistor is coupled to the first terminal of the fifth transistor, and the control terminal of the sixth transistor receives the second selecting signal; a seventh transistor, having a first terminal, a second terminal and a control terminal, wherein the first terminal of the seventh transistor is coupled to the second terminal of the third transistor, and the control terminal of the seventh transistor receives the second reference voltage; an eighth transistor, having a first terminal, a second terminal and a control terminal, wherein the first terminal of the eighth transistor is coupled to the second terminal of the seventh transistor, the second terminal of the eighth transistor is coupled to the first terminal of the seventh transistor, and the control terminal of the eighth transistor receives the first selecting signal; a ninth transistor, having a first terminal, a second terminal and a control terminal, wherein the first terminal of the ninth transistor receives the first reference voltage, and the second terminal of the ninth transistor generates the first output signal, and the control terminal of the ninth transistor is coupled to the second terminal of the fifth transistor and the second terminal of the seventh transistor; a tenth transistor, having a first terminal, a second terminal and a control terminal, wherein the first terminal of the tenth transistor receives the second reference voltage, the second terminal of the tenth transistor is coupled to the second terminal of the ninth transistor, and the control terminal of the tenth transistor is coupled to the control terminal of the ninth transistor.

Each of the first transistor, the third transistor, the fifth transistor, the seventh transistor and the ninth transistor is a P-type transistor, and each of the second transistor, the fourth transistor, the sixth transistor, the eighth transistor and the tenth transistor is an N-type transistor.

Each of the plurality of selecting modules comprises:
a first transistor, having a first terminal, a second terminal and a control terminal, wherein the first terminal of the first transistor receives a first reference voltage, and the control terminal of the first transistor receives the second selecting signal; a second transistor, having a first terminal, a second terminal and a control terminal, wherein the first terminal of the second transistor receives the first reference voltage, the second terminal of the second transistor is coupled to the second terminal of the first transistor, and the control terminal of the second transistor receives the first input signal; a third transistor, having a first terminal, a second terminal and a control terminal, wherein the first terminal of the third transistor is coupled to the second terminal of the first transistor, and the control terminal of the third transistor receives the first selecting signal; a fourth transistor, having a first terminal, a second terminal and a control terminal, wherein the first terminal of the fourth transistor is coupled to the first terminal of the third transistor, the second terminal of the fourth transistor is coupled to the second terminal of the third transistor, and the control terminal of the fourth transistor receives the second input signal; a fifth transistor, having a first terminal, a second terminal and a control terminal, wherein the second terminal of the fifth transistor is coupled to the second terminal of the third transistor, and the control terminal of the fifth transistor receives the first selecting signal; a sixth transistor, having a first terminal, a second terminal and a control terminal, wherein the second terminal of the sixth transistor is coupled to the second terminal of fifth transistor, and the control terminal of the sixth transistor receives the second selecting signal; a seventh transistor, having a first terminal, a second terminal and a control terminal, wherein the first terminal of the seventh transistor receives the second reference voltage, the second terminal of the seventh transistor is coupled to the first terminal of the fifth transistor, and the control terminal of the seventh transistor receives the first input signal; an eighth transistor, having a first terminal, a second terminal and a control terminal, wherein the first terminal of the eighth transistor receives the second reference voltage, the second terminal of the eighth transistor is coupled to the first terminal of the sixth transistor, and the control terminal of the eighth transistor receives the second input signal; a ninth transistor, having a first terminal, a second terminal and a control terminal, wherein the first terminal of the ninth transistor receives the first reference voltage, the second terminal of the ninth transistor generates the first output signal, and the control terminal of the ninth transistor is coupled to the second terminal of the third transistor; and a tenth transistor, having a first terminal, a second terminal and a control terminal, wherein the first terminal of the tenth transistor receives the second reference voltage, the second terminal of the tenth transistor is coupled to the second terminal of the ninth transistor, and the control terminal of the tenth transistor is coupled to the control terminal of the ninth transistor.

Each of the first transistor, the second transistor, the third transistor, the fourth transistor and the ninth transistor may be a P-type transistor, and each of the fifth transistor, the sixth transistor, the seventh transistor, the eighth transistor and the tenth transistor may be an N-type transistor.

### BRIEF DESCRIPTION OF THE DRAWINGS

The disclosure can be more fully understood by reading the subsequent detailed description and examples with references made to the accompanying drawings, wherein:
FIG. 1 is a schematic view of an integrated circuit device according to an embodiment of the disclosure;
FIG. 2 is a schematic view of an integrated circuit device according to another embodiment of the disclosure;
FIG. 3 is a schematic view of an integrated circuit device according to another embodiment of the disclosure;
FIG. 4 is a schematic view of a layout of a chip device according to an embodiment of the disclosure;
FIG. 5 is a schematic view of an integrated circuit device according to an embodiment of the disclosure;
FIG. 6 is a circuit diagram of a selecting module in FIG. 5; and
FIG. 7 is a circuit diagram of a selecting module in FIG. 5 according to the invention.

### DETAILED DESCRIPTION OF THE DISCLOSURE

Technical terms of the present disclosure are based on general definition in the technical field of the present disclosure.

In each of the following embodiments, the same reference number represents the same or a similar element or component.

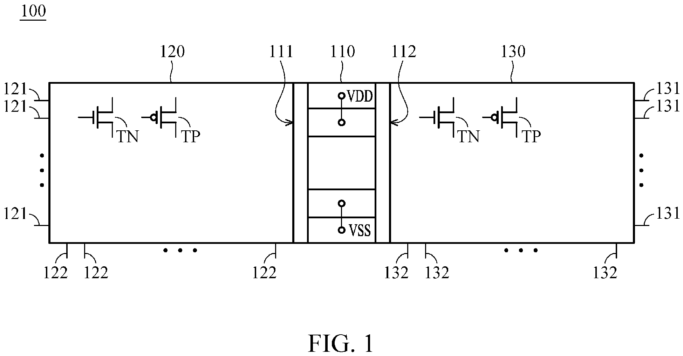

FIG. 1 is a schematic view of an integrated circuit device according to an embodiment of the disclosure. Please refer to FIG. 1. The integrated circuit device 100 includes a reference voltage channel 110, a first cell 120 and a second cell 130.

The reference voltage channel 110 is configured to provide a first reference voltage VDD and a second reference voltage VSS. In the embodiment, the first reference voltage VDD is, for example, a system voltage, and the second reference voltage VSS is, for example, a ground voltage, but the disclosure is not limited thereto.

The first cell 120 is coupled to the reference voltage channel 110, and is configured to receive the first reference voltage VDD and the second reference voltage VSS. In addition, the first cell 120 is disposed on a first side 111 of the reference voltage channel 110.

The second cell 130 is coupled to the reference voltage channel 110, and is configured to receive the first reference voltage VDD and the second reference voltage VSS. In addition, the second cell 130 is disposed on a second side 112 of the reference voltage channel 110. The second side 112 is opposite to the first side 111. That is, the first cell 120 and the second cell 130 are disposed at two opposite sides of the reference voltage channel 110. Therefore, the first cell 120 and the second cell 130 may share the same reference voltage channel 110, the first cell 120 and the second cell 130 may share the same first reference voltage VDD and the same second reference voltage VSS, so as to effectively decrease the area and power consumption of the integrated circuit device 100.

In some embodiments, each of the first cell 120 and the second cell 130 may include a plurality of transistors. In addition, the transistors may at least include an N-type transistor TN and a P-type transistor TP, but the disclosure is not limited thereto. In other embodiments, the transistors may also a plurality of N-type transistors TN and a plurality of P-type transistors TP.

In the embodiment, the number of transistors of the first cell 120 is, for example, equal to the number of transistors of the second cell 130. That is, the area of the first cell 120 is equal to the area the second cell 130.

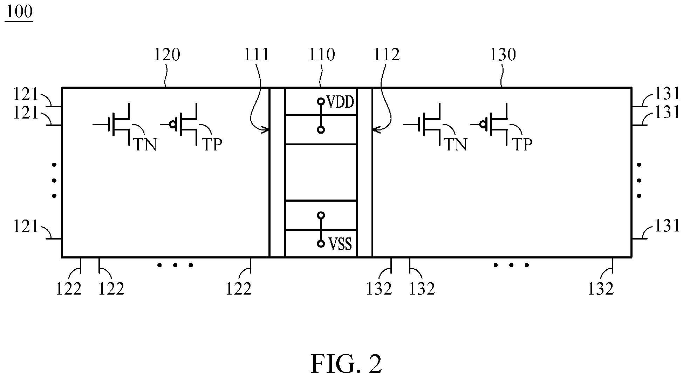

In some embodiments, the number of transistors of the first cell 120 is, for example, less than the number of transistors of the second cell 130, as shown in FIG. 2. That is, the area of the first cell 120 is less than the area of the second cell 130.

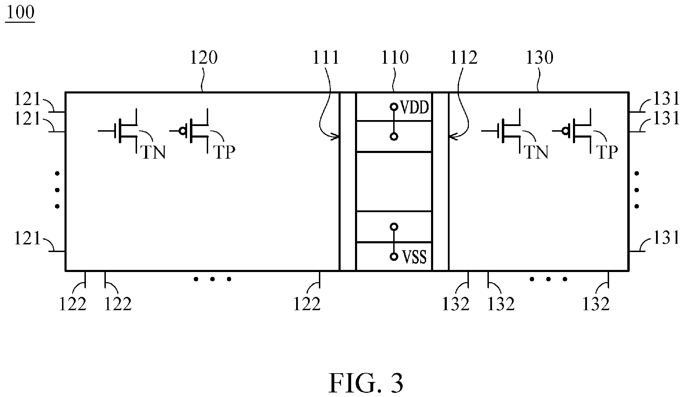

In some embodiments, the number of transistors of the first cell 120 is, for example, greater than the number of transistors of the second cell 130, as shown in FIG. 3. That is, the area of the first cell 120 is greater than the area of the second cell 130.

In some embodiments, the first cell 120 may at least include an input terminal 121 and an output terminal 122. The input terminal 121 is configured to receive an input signal. The output terminal 122 is configured to output an output signal. In other embodiments, the first cell 120 may include a plurality of input terminals 121 and a plurality of output terminals 122. In addition, the number of input terminals 121 and the number of output terminals 122 may be the same or different.

In addition, the second cell 130 may at least include an input terminal 131 and an output terminal 132. The input terminal 131 is configured to receive an input signal. The output terminal 132 is configured to output an output signal. In other embodiments, the second cell 130 may include a plurality of input terminals 131 and a plurality of output terminals 132. In addition, the number of input terminals 131 and the number of output terminals 132 may be the same or different.

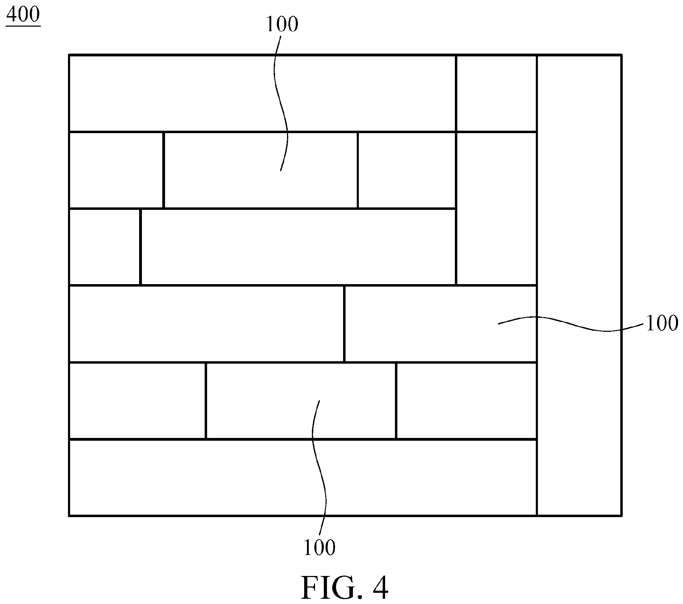

FIG. 4 is a schematic view of a layout of a chip device according to an embodiment of the disclosure. Please refer to FIG. 4. The chip device 400 may include at least one integrated circuit device 100 in FIG. 1, FIG. 2 and/or FIG. 3. Therefore, the chip device 400 may also achieve the same effect for decreasing area and power consumption. In FIG. 4, the chip device 400 includes three integrated circuits 100, but the disclosure is not limited thereto. In some embodiment, the chip device 400 may also include two or more than three integrated circuits 100. In addition, the disposing position of the integrated circuits 100 in FIG. 4 is one exemplary embodiment of the disclosure, but the disclosure is not limited thereto. The user may adjust the disposing position of the integrated circuits 100 according to the requirements thereof. Therefore, the same effect may also be achieved.

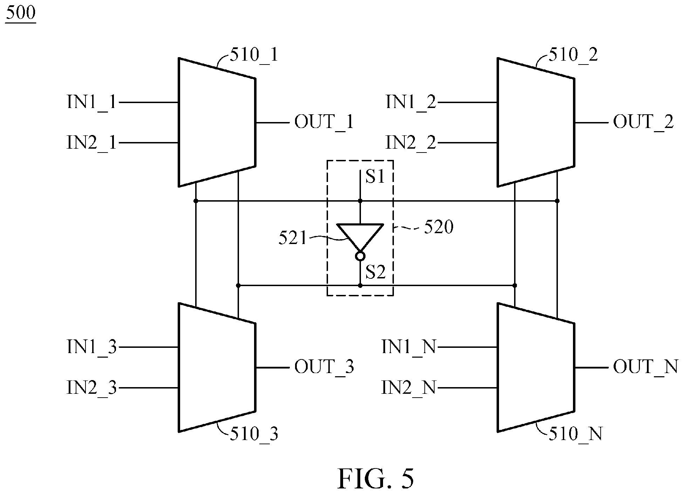

FIG. 5 is a schematic view of an integrated circuit device according to an embodiment of the disclosure. Please refer to FIG. 5. The integrated circuit device 500 includes a plurality of selecting modules 510_1~510_N and a selecting signal providing module 520, wherein N is a positive integer greater than 1.

Each of the selecting modules 510_1~510_N is configured to receive a first input signal IN1_1~IN1_N, a second input signal IN2_1~IN2_N, a first selecting signal S1 and a second selecting signal S2, and select the first input signal IN1_1~IN1_N or the second input signal IN2_1~IN2_N to generate an output signal OUT_1~OUT_N according to a first selecting signal S1 and a second selecting signal S2. For example, the selecting modules 510_1 receives the first input signal IN1_1, the second input signal IN2_1, the first selecting signal S1 and the second selecting signal S2, and selects the first input signal IN1_1 or the second input signal IN2_1 to generate the output signal OUT_1 according to the first selecting signal S1 and the second selecting signal S2.

The selecting modules 510_2 receives the first input signal IN1_2, the second input signal IN2_2, the first selecting signal S1 and the second selecting signal S2, and selects the first input signal IN1_2 or the second input signal IN2_2 to generate the output signal OUT_2 according to the first selecting signal S1 and the second selecting signal S2.... The selecting modules 510_N receives the first input signal IN1_N, the second input signal IN2_N, the first selecting signal S1 and the second selecting signal S2, and selects the first input signal IN1_N or the second input signal IN2_N to generate the output signal OUT_N according to the first selecting signal S1 and the second selecting signal S2. In the embodiments, each of the selecting modules 510_1~510_N may include, for example, a multiplexer (MUX).

The selecting signal providing module 520 is coupled to the selecting module 510_1~510_N. The selecting signal providing module 520 is configured to provide the first selecting signal S1 and the second selecting signal S2.

In the embodiment, the first selecting signal S1 and the second selecting signal S2 are inverted. In addition, the selecting signal providing module 520 may include an inverter 521. The inverter 521 has an input terminal and an output terminal. The input terminal of the inverter 521 receives the first selecting signal S1, and the output terminal of the inverter 521 outputs the second selecting signal S2. Therefore, the selecting modules 510_1~510_N may share the same selecting signal providing module 520, i.e., the selecting modules 510_1~510_N may share the same first selecting signal S1 and the same second selecting signal S2, so as to decrease the area and power consumption of the integrated circuit device 500.

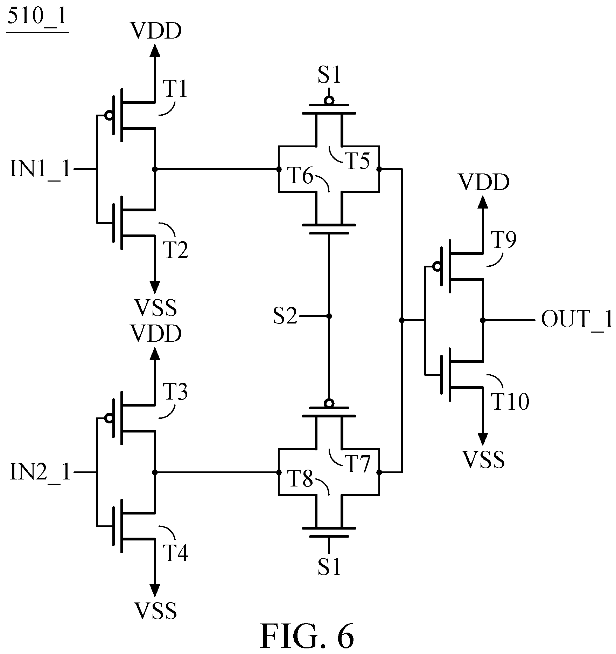

In some embodiments, the selecting module 510_1 may include a first transistor T1, a second transistor T2, a third transistor T3, a fourth transistor T4, a fifth transistor T5, a sixth transistor T6, a seventh transistor T7, an eighth transistor T8, a ninth transistor T9 and a tenth transistor T10, as shown in FIG. 6. The internal components and the connection relationship thereof of selecting modules 510_2~510_N are the same as the internal components and the connection relationship thereof of the selecting module 510_1. Accordingly, the selecting modules 510_2~510_N may refer to the description of the embodiment in FIG. 6, and the description thereof is not repeated thereto.

The first transistor T1 has a first terminal, a second terminal and a control terminal. The first terminal of the first transistor T1 receives a first reference voltage VDD. The control terminal of the first transistor T1 receives the first input signal IN1_1. The second transistor T2 has a first terminal, a second terminal and a control terminal. The first terminal of the second transistor T2 receives a second reference voltage VSS. The second terminal of the second transistor T2 is coupled to the second terminal of the first transistor T1. The control terminal of the second transistor T2 is coupled to the control terminal of the first transistor T1. In the embodiments, the first reference voltage VDD is, for example, a system voltage, and the second reference voltage VSS is, for example, a ground voltage.

The third transistor T3 has a first terminal, a second terminal and a control terminal. The first terminal of the third transistor T3 receives the first reference voltage VDD. The control terminal of the third transistor T3 receives the second input signal IN2_1. The fourth transistor T4 has a first terminal, a second terminal and a control terminal. The first terminal of the fourth transistor T4 receives the second reference voltage VSS. The second terminal of the fourth transistor T4 is coupled to the second terminal of the third transistor T3. The control terminal of the fourth transistor T4 is coupled to the control terminal of the third transistor T3.

The fifth transistor T5 has a first terminal, a second terminal and a control terminal. The first terminal of the fifth transistor T5 is coupled to the second terminal of the first transistor T1. The control terminal of the fifth transistor T5 receives the first selecting signal S1. The sixth transistor T6 has a first terminal, a second terminal and a control terminal. The first terminal of the sixth transistor T6 is coupled to the second terminal of the fifth transistor T5. The second terminal of the sixth transistor T6 is coupled to the first terminal of the fifth transistor T5. The control terminal of the sixth transistor T6 receives the second selecting signal S2.

The seventh transistor T7 has a first terminal, a second terminal and a control terminal. The first terminal of the seventh transistor T7 is coupled to the second terminal of the third transistor T3. The control terminal of the seventh transistor T7 receives the second reference voltage S2. The eighth transistor T8 has a first terminal, a second terminal and a control terminal. The first terminal of the eighth transistor T8 is coupled to the second terminal of the seventh transistor T7. The second terminal of the eighth transistor T8 is coupled to the first terminal of the seventh transistor T7. The control terminal of the eighth transistor T8 receives the first selecting signal S1.

The ninth transistor T9 has a first terminal, a second terminal and a control terminal. The first terminal of the ninth transistor T9 receives the first reference voltage VDD. The second terminal of the ninth transistor T9 generates the first output signal OUT_1. The control terminal of the ninth transistor T9 is coupled to the second terminal of the fifth transistor T5 and the second terminal of the seventh transistor T7. The tenth transistor T10 has a first terminal, a second terminal and a control terminal. The first terminal of the tenth transistor T10 receives the second reference voltage VSS. The second terminal of the tenth transistor T10 is coupled to the second terminal of the ninth transistor T9. The control terminal of the tenth transistor T10 is coupled to the control terminal of the ninth transistor T9.

In some embodiments, each of the first transistor T1, the third transistor T3, the fifth transistor T5, the seventh transistor T7 and the ninth transistor T9 is, for example, a P-type transistor. Each of the first terminals of the first transistor T1, the third transistor T3, the fifth transistor T5, the seventh transistor T7 and the ninth transistor T9 is, for example, a source terminal of the P-type transistor. Each of the second terminals of the first transistor T1, the third transistor T3, the fifth transistor T5, the seventh transistor T7 and the ninth transistor T9 is, for example, a drain terminal of the P-type transistor. Each of the control terminals of the first transistor T1, the third transistor T3, the fifth transistor T5, the seventh transistor T7 and the ninth transistor T9 is, for example, a gate terminal of the P-type transistor.

In addition, each of the second transistor T2, the fourth transistor T4, the sixth transistor T6, the eighth transistor T8 and the tenth transistor T10 is, for example, an N-type transistor. Each of the first terminals of the second transistor T2, the fourth transistor T4, the sixth transistor T6, the eighth transistor T8 and the tenth transistor T10 is, for example, a source terminal of the N-type transistor. Each of the second terminals of the second transistor T2, the fourth transistor T4, the sixth transistor T6, the eighth transistor T8 and the tenth transistor T10 is, for example, a drain terminal of the N-type transistor. Each of the control terminals of the second transistor T2, the fourth transistor T4, the sixth transistor T6, the eighth transistor T8 and the tenth transistor T10 is, for example, a gate terminal of the P-type transistor.

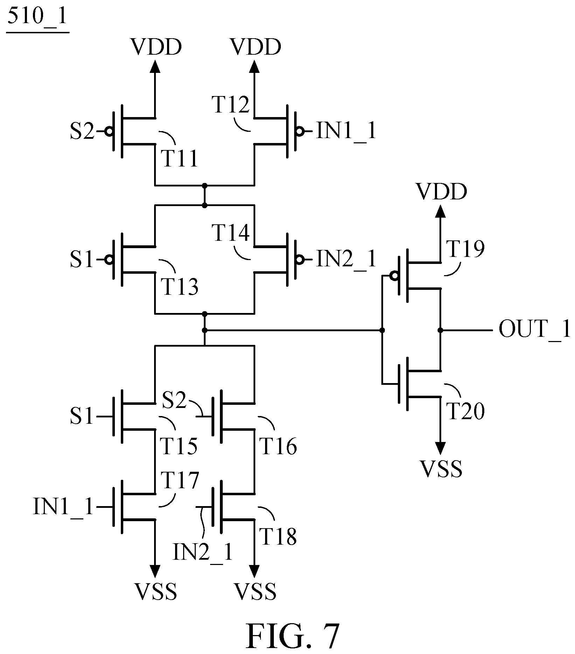

According to the invention, the selecting module 510_1 includes a first transistor T11, a second transistor T12, a third transistor T13, a fourth transistor T14, a fifth transistor T15, a sixth transistor T16, a seventh transistor T17, an eighth transistor T18, a ninth transistor T19 and a tenth transistor T20, as shown in FIG. 7. The internal components and the connection relationship thereof of selecting modules 510_2~510_N are the same as the internal components and the connection relationship thereof of the selecting module 510_1. Accordingly, the selecting modules 510_2~510_N may refer to the description of the embodiment in FIG. 6, and the description thereof is not repeated thereto.

The first transistor T11 has a first terminal, a second terminal and a control terminal. The first terminal of the first transistor T11 receives a first reference voltage VDD. The control terminal of the first transistor T11 receives the second selecting signal S2. The second transistor T12 has a first terminal, a second terminal and a control terminal. The first terminal of the second transistor T12 receives the first reference voltage VDD. The second terminal of the second transistor T12 is coupled to the second terminal of the first transistor T11. The control terminal of the second transistor T12 receives the first input signal IN1_1.

The third transistor T13 has a first terminal, a second terminal and a control terminal. The first terminal of the third transistor T13 is coupled to the second terminal of the first transistor T11. The control terminal of the third transistor T13 receives the first selecting signal S1. The fourth transistor T14 has a first terminal, a second terminal and a control terminal. The first terminal of the fourth transistor T14 is coupled to the first terminal of the third transistor T13. The second terminal of the fourth transistor T14 is coupled to the second terminal of the third transistor T13. The control terminal of the fourth transistor T14 receives the second input signal IN2_1.

The fifth transistor T15 has a first terminal, a second terminal and a control terminal. The second terminal of the fifth transistor T15 is coupled to the second terminal of the third transistor T13. The control terminal of the fifth transistor T15 receives the first selecting signal S1. The sixth transistor T16 has a first terminal, a second terminal and a control terminal. The second terminal of the sixth transistor T16 is coupled to the second terminal of fifth transistor T15. The control terminal of the sixth transistor T16 receives the second selecting signal S2.

The seventh transistor T17 has a first terminal, a second terminal and a control terminal. The first terminal of the seventh transistor T17 receives the second reference voltage VSS. The second terminal of the seventh transistor T17 is coupled to the first terminal of the fifth transistor T15. The control terminal of the seventh transistor T17 receives the first input signal IN1_1. The eighth transistor T18 has a first terminal, a second terminal and a control terminal. The first terminal of the eighth transistor T18 receives the second reference voltage VSS. The second terminal of the eighth transistor T18 is coupled to the first terminal of the sixth transistor T16. The control terminal of the eighth transistor T18 receives the second input signal IN2_1.

The ninth transistor T19 has a first terminal, a second terminal and a control terminal. The first terminal of the ninth transistor T19 receives the first reference voltage VDD. The second terminal of the ninth transistor T19 generates the first output signal OUT_1. The control terminal of the ninth transistor T19 is coupled to the second terminal of the third transistor T13. The tenth transistor T20 has a first terminal, a second terminal and a control terminal. The first terminal of the tenth transistor T20 receives the second reference voltage VSS. The second terminal of the tenth transistor T20 is coupled to the second terminal of the ninth transistor T19. The control terminal of the tenth transistor T20 is coupled to the control terminal of the ninth transistor T19.

In some embodiments, each of the first transistor T11, the second transistor T12, the third transistor T13, the fourth transistor T14 and the ninth transistor T19 is, for example, a P-type transistor. Each of the first terminals of the first transistor T11, the second transistor T12, the third transistor T13, the fourth transistor T14 and the ninth transistor T19 is, for example, a source terminal of the P-type transistor. Each of the second terminals of the first transistor T11, the second transistor T12, the third transistor T13, the fourth transistor T14 and the ninth transistor T19 is, for example, a drain terminal of the P-type transistor. Each of the control terminals of the first transistor T11, the second transistor T12, the third transistor T13, the fourth transistor T14 and the ninth transistor T19 is, for example, a gate terminal of the P-type transistor.

In addition, each of the fifth transistor T15, the sixth transistor T16, the seventh transistor T17, the eighth transistor T18 and the tenth transistor T20 is, for example, an N-type transistor. Each of the first terminals the fifth transistor T15, the sixth transistor T16, the seventh transistor T17, the eighth transistor T18 and the tenth transistor T20 is, for example, a source terminal of the N-type transistor. Each of the second terminals of the fifth transistor T15, the sixth transistor T16, the seventh transistor T17, the eighth transistor T18 and the tenth transistor T20 is, for example, a drain terminal of the N-type transistor. Each of the control terminals of the fifth transistor T15, the sixth transistor T16, the seventh transistor T17, the eighth transistor T18 and the tenth transistor T20 is, for example, a gate terminal of the P-type transistor.

In summary, according to the integrated circuit device and chip device disclosed by the present disclosure, the first cell and the second cell share the same reference voltage channel (i.e., the same first reference voltage and the same second reference voltage) or the selecting modules share the same selecting signal providing module (i.e., the same first selecting signal and the same second selecting signal). Therefore, the area and power consumption of the integrated circuit device may be effectively decreased.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An integrated circuit device (500), comprising:
a plurality of selecting modules (510_1, 510_2, 510_3, 510_N), wherein each of the plurality of selecting modules is configured to receive a first input signal (IN1_1, IN1_2, IN1_3, IN1_N), a second input signal (IN2_1, IN2_2, IN2_3, IN2_N), a first selecting signal (S1) and a second selecting signal (S2), and select the first input signal or the second input signal to generate an output signal (OUT_1, OUT_2, OUT_3, OUT_N) according to the first selecting signal and the second selecting signal; and
a selecting signal providing module (520), configured to provide the first selecting signal (S1) and the second selecting signal (S2);
wherein each of the plurality of selecting modules (510_1, 510_2, 510_3, 510_N) comprises:
a first transistor (T11), having a first terminal, a second terminal and a control terminal, wherein the first terminal of the first transistor receives a first reference voltage (VDD), and the control terminal of the first transistor receives the second selecting signal (S2);
a second transistor (T12), having a first terminal, a second terminal and a control terminal, wherein the first terminal of the second transistor receives the first reference voltage (VDD), the second terminal of the second transistor is coupled to the second terminal of the first transistor, and the control terminal of the second transistor receives the first input signal (IN1_1);
a third transistor (T13), having a first terminal, a second terminal and a control terminal, wherein the first terminal of the third transistor is coupled to the second terminal of the first transistor, and the control terminal of the third transistor receives the first selecting signal (S1);
a fourth transistor (T14), having a first terminal, a second terminal and a control terminal, wherein the first terminal of the fourth transistor is coupled to the first terminal of the third transistor, the second terminal of the fourth transistor is coupled to the second terminal of the third transistor, and the control terminal of the fourth transistor receives the second input signal (IN2_1);
a fifth transistor (T15), having a first terminal, a second terminal and a control terminal, wherein the second terminal of the fifth transistor is coupled to the second terminal of the third transistor, and the control terminal of the fifth transistor receives the first selecting signal (S1);
a sixth transistor (T16), having a first terminal, a second terminal and a control terminal, wherein the second terminal of the sixth transistor is coupled to the second terminal of fifth transistor, and the control terminal of the sixth transistor receives the second selecting signal (S2);
a seventh transistor (T17), having a first terminal, a second terminal and a control terminal, wherein the first terminal of the seventh transistor receives a second reference voltage (VSS), the second terminal of the seventh transistor is coupled to the first terminal of the fifth transistor, and the control terminal of the seventh transistor receives the first input signal (IN1_1);
an eighth transistor (T18), having a first terminal, a second terminal and a control terminal, wherein the first terminal of the eighth transistor receives the second reference voltage (VSS), the second terminal of the eighth transistor is coupled to the first terminal of the sixth transistor, and the control terminal of the eighth transistor receives the second input signal (IN2_1);
a ninth transistor (T19), having a first terminal, a second terminal and a control terminal, wherein the first terminal of the ninth transistor receives the first reference voltage (VDD), the second terminal of the ninth transistor generates the first output signal (OUT_1), and the control terminal of the ninth transistor is coupled to the second terminal of the third transistor; and
a tenth transistor (T20), having a first terminal, a second terminal and a control terminal, wherein the first terminal of the tenth transistor receives the second reference voltage (VSS), the second terminal of the tenth transistor is coupled to the second terminal of the ninth transistor, and the control terminal of the tenth transistor is coupled to the control terminal of the ninth transistor.

2. The integrated circuit device as claimed in claim 1, wherein the first selecting signal (S1) and the second selecting signal (S2) are inverted.

3. The integrated circuit device as claimed in claim 1 or 2, wherein the selecting signal providing module (520) comprises:
an inverter (521), having an input terminal and an output terminal, wherein the input terminal of the inverter receives the first selecting signal (S1), and the output terminal of the inverter outputs the second selecting signal (S2).

4. The integrated circuit device as claimed in any one of claims 1 to 3, wherein each of the plurality of selecting modules comprises a multiplexer.

5. The integrated circuit device as claimed in claim 1, wherein each of the first transistor (T11), the second transistor (T12), the third transistor (T13), the fourth transistor (T14) and the ninth transistor (T19) is a P-type transistor, and each of the fifth transistor (T15), the sixth transistor (T16), the seventh transistor (T17), the eighth transistor (T18) and the tenth transistor (T20) is an N-type transistor.

6. A chip device (400), comprising at least one integrated circuit device (500) as claimed in any one of claims 1 to 5.

## Patentansprüche

1. Integrierte Schaltungsvorrichtung (500), umfassend:
eine Vielzahl von Auswahlmodulen (510_1, 510_2, 510_3, 510_N), wobei jedes der Vielzahl von Auswahlmodulen so konfiguriert ist, dass es ein erstes Eingangssignal (EIN1_1, EIN1_2, EIN1_3, EIN1_N), ein zweites Eingangssignal (EIN2_1, EIN2_2, EIN2_3, EIN2_N), ein erstes Auswahlsignal (S1) und ein zweites Auswahlsignal (S2) empfängt und das erste Eingangssignal oder das zweite Eingangssignal auswählt, um ein Ausgangssignal (AUS_1, AUS_2, AUS_3, AUS_N) entsprechend dem ersten Auswahlsignal und dem zweiten Auswahlsignal zu erzeugen; und
ein Auswahlsignalbereitstellungsmodul (520), das so konfiguriert ist, dass es das erste Auswahlsignal (S1) und das zweite Auswahlsignal (S2) bereitstellt;
wobei jedes der Vielzahl von Auswahlmodulen (510_1, 510_2, 510_3, 510_N) umfasst:
einen ersten Transistor (T11), der einen ersten Anschluss, einen zweiten Anschluss und einen Steueranschluss aufweist, wobei der erste Anschluss des ersten Transistors eine erste Referenzspannung (VDD) empfängt und der Steueranschluss des ersten Transistors das zweite Auswahlsignal (S2) empfängt;
einen zweiten Transistor (T12), der einen ersten Anschluss, einen zweiten Anschluss und einen Steueranschluss aufweist, wobei der erste Anschluss des zweiten Transistors die erste Referenzspannung (VDD) empfängt, der zweite Anschluss des zweiten Transistors mit dem zweiten Anschluss des ersten Transistors gekoppelt ist und der Steueranschluss des zweiten Transistors das erste Eingangssignal (EIN1_1) empfängt;
einen dritten Transistor (T13), der einen ersten Anschluss, einen zweiten Anschluss und einen Steueranschluss aufweist, wobei der erste Anschluss des dritten Transistors mit dem zweiten Anschluss des ersten Transistors gekoppelt ist und der Steueranschluss des dritten Transistors das erste Auswahlsignal (S1) empfängt;
einen vierten Transistor (T14), der einen ersten Anschluss, einen zweiten Anschluss und einen Steueranschluss aufweist, wobei der erste Anschluss des vierten Transistors mit dem ersten Anschluss des dritten Transistors gekoppelt ist, der zweite Anschluss des vierten Transistors mit dem zweiten Anschluss des dritten Transistors gekoppelt ist und der Steueranschluss des vierten Transistors das zweite Eingangssignal (EIN2_1) empfängt;
einen fünften Transistor (T15), der einen ersten Anschluss, einen zweiten Anschluss und einen Steueranschluss aufweist, wobei der zweite Anschluss des fünften Transistors mit dem zweiten Anschluss des dritten Transistors gekoppelt ist und der Steueranschluss des fünften Transistors das erste Auswahlsignal (S1) empfängt;
einen sechsten Transistor (T16), der einen ersten Anschluss, einen zweiten Anschluss und einen Steueranschluss aufweist, wobei der zweite Anschluss des sechsten Transistors mit dem zweiten Anschluss des fünften Transistors gekoppelt ist und der Steueranschluss des sechsten Transistors das zweite Auswahlsignal (S2) empfängt;
einen siebten Transistor (T17), der einen ersten Anschluss, einen zweiten Anschluss und einen Steueranschluss aufweist, wobei der erste Anschluss des siebten Transistors eine zweite Referenzspannung (VSS) empfängt, der zweite Anschluss des siebten Transistors mit dem ersten Anschluss des fünften Transistors gekoppelt ist und der Steueranschluss des siebten Transistors das erste Eingangssignal (EIN1_1) empfängt;
einen achten Transistor (T18), der einen ersten Anschluss, einen zweiten Anschluss und einen Steueranschluss aufweist, wobei der erste Anschluss des achten Transistors die zweite Referenzspannung (VSS) empfängt, der zweite Anschluss des achten Transistors mit dem ersten Anschluss des sechsten Transistors gekoppelt ist und der Steueranschluss des achten Transistors das zweite Eingangssignal (EIN2_1) empfängt;
einen neunten Transistor (T19), der einen ersten Anschluss, einen zweiten Anschluss und einen Steueranschluss aufweist, wobei der erste Anschluss des neunten Transistors die erste Referenzspannung (VDD) empfängt, der zweite Anschluss des neunten Transistors das erste Ausgangssignal (AUS_1) erzeugt und der Steueranschluss des neunten Transistors mit dem zweiten Anschluss des dritten Transistors gekoppelt ist; und
einen zehnten Transistor (T20), der einen ersten Anschluss, einen zweiten Anschluss und einen Steueranschluss aufweist, wobei der erste Anschluss des zehnten Transistors die zweite Referenzspannung (VSS) empfängt, der zweite Anschluss des zehnten Transistors mit dem zweiten Anschluss des neunten Transistors gekoppelt ist und der Steueranschluss des zehnten Transistors mit dem Steueranschluss des neunten Transistors gekoppelt ist.

2. Integrierte Schaltungsvorrichtung nach Anspruch 1, wobei das erste Auswahlsignal (S1) und das zweite Auswahlsignal (S2) invertiert sind.

3. Integrierte Schaltungsvorrichtung nach Anspruch 1 oder 2, wobei das Auswahlsignalbereitstellungsmodul (520) umfasst:
einen Inverter (521), der einen Eingangsanschluss und einen Ausgangsanschluss aufweist, wobei der Eingangsanschluss des Inverters das erste Auswahlsignal (S1) empfängt und der Ausgangsanschluss des Inverters das zweite Auswahlsignal (S2) ausgibt.

4. Integrierte Schaltungsvorrichtung nach einem der Ansprüche 1 bis 3, wobei jedes der Vielzahl von Auswahlmodulen einen Multiplexer umfasst.

5. Integrierte Schaltungsvorrichtung nach Anspruch 1, wobei jeder von dem ersten Transistor (T11), dem zweiten Transistor (T12), dem dritten Transistor (T13), dem vierten Transistor (T14) und dem neunten Transistor (T19) ein P-Typ-Transistor ist und jeder von dem fünften Transistor (T15), dem sechsten Transistor (T16), dem siebten Transistor (T17), dem achten Transistor (T18) und dem zehnten Transistor (T20) ein N-Typ-Transistor ist.

6. Chipvorrichtung (400), die mindestens eine integrierte Schaltungsvorrichtung (500) nach einem der Ansprüche 1 bis 5 umfasst.

## Revendications

1. Dispositif à circuit intégré (500), comprenant :
une pluralité de modules de sélection (510_1, 510_2, 510_3, 510_N), dans lequel chacun parmi la pluralité de modules de sélection est configuré pour recevoir un premier signal d'entrée (IN1_1, IN1_2, IN1_3, IN1_N), un second signal d'entrée (IN2_1, IN2_2, IN2_3, IN2_N), un premier signal de sélection (S1) et un second signal de sélection (S2), et sélectionner le premier signal d'entrée ou le second signal d'entrée pour générer un signal de sortie (OUT_1, OUT_2, OUT_3, OUT_N) en fonction du premier signal de sélection et du second signal de sélection ; et
un module de fourniture de signal de sélection (520), configuré pour fournir le premier signal de sélection (S1) et le second signal de sélection (S2) ;
dans lequel chacun parmi la pluralité de modules de sélection (510_1, 510_2, 510_3,
510_N) comprend :
un premier transistor (T11), présentant une première borne, une seconde borne et une borne de commande, dans lequel la première borne du premier transistor reçoit une première tension de référence (VDD), et la borne de commande du premier transistor reçoit le second signal de sélection (S2) ;
un deuxième transistor (T12), présentant une première borne, une seconde borne et une borne de commande, dans lequel la première borne du deuxième transistor reçoit la première tension de référence (VDD), la seconde borne du deuxième transistor est couplée à la seconde borne du premier transistor, et la borne de commande du deuxième transistor reçoit le premier signal d'entrée (IN1_1) ;
un troisième transistor (T13), présentant une première borne, une seconde borne et une borne de commande, dans lequel la première borne du troisième transistor est couplée à la seconde borne du premier transistor, et la borne de commande du troisième transistor reçoit le premier signal de sélection (S1) ;
un quatrième transistor (T14), présentant une première borne, une seconde borne et une borne de commande, dans lequel la première borne du quatrième transistor est couplée à la première borne du troisième transistor, la seconde borne du quatrième transistor est couplée à la seconde borne du troisième transistor, et la borne de commande du quatrième transistor reçoit le second signal d'entrée (IN2_1) ;
un cinquième transistor (T15), présentant une première borne, une seconde borne et une borne de commande, dans lequel la seconde borne du cinquième transistor est couplée à la seconde borne du troisième transistor, et la borne de commande du cinquième transistor reçoit le premier signal de sélection (S1) ;
un sixième transistor (T16), présentant une première borne, une seconde borne et une borne de commande, dans lequel la seconde borne du sixième transistor est couplée à la seconde borne du cinquième transistor, et la borne de commande du sixième transistor reçoit le second signal de sélection (S2) ;
un septième transistor (T17), présentant une première borne, une seconde borne et une borne de commande, dans lequel la première borne du septième transistor reçoit une seconde tension de référence (VSS), la seconde borne du septième transistor est couplée à la première borne du cinquième transistor, et la borne de commande du septième transistor reçoit le premier signal d'entrée (IN1_1) ;
un huitième transistor (T18), présentant une première borne, une seconde borne et une borne de commande, dans lequel la première borne du huitième transistor reçoit la seconde tension de référence (VSS), la seconde borne du huitième transistor est couplée à la première borne du sixième transistor, et la borne de commande du huitième transistor reçoit le second signal d'entrée (IN2_1) ;
un neuvième transistor (T19), présentant une première borne, une seconde borne et une borne de commande, dans lequel la première borne du neuvième transistor reçoit la première tension de référence (VDD), la seconde borne du neuvième transistor génère le premier signal de sortie (OUT_1), et la borne de commande du neuvième transistor est couplée à la seconde borne du troisième transistor ; et
un dixième transistor (T20), présentant une première borne, une seconde borne et une borne de commande, dans lequel la première borne du dixième transistor reçoit la seconde tension de référence (VSS), la seconde borne du dixième transistor est couplée à la seconde borne du neuvième transistor, et la borne de commande du dixième transistor est couplée à la borne de commande du neuvième transistor.

2. Dispositif à circuit intégré selon la revendication 1, dans lequel le premier signal de sélection (S1) et le second signal de sélection (S2) sont inversés.

3. Dispositif à circuit intégré selon la revendication 1 ou 2, dans lequel le module de fourniture de signal de sélection (520) comprend :
un onduleur (521), présentant une borne d'entrée et une borne de sortie, dans lequel la borne d'entrée de l'onduleur reçoit le premier signal de sélection (S1), et la borne de sortie de l'onduleur émet en sortie le second signal de sélection (S2).

4. Dispositif à circuit intégré selon l'une quelconque des revendications 1 à 3, dans lequel chacun parmi la pluralité de modules de sélection comprend un multiplexeur.

5. Dispositif à circuit intégré selon la revendication 1, dans lequel chacun parmi le premier transistor (T11), le deuxième transistor (T12), le troisième transistor (T13), le quatrième transistor (T14) et le neuvième transistor (T19) est un transistor de type P, et chacun parmi le cinquième transistor (T15), le sixième transistor (T16), le septième transistor (T17), le huitième transistor (T18) et le dixième transistor (T20) est un transistor de type N.

6. Dispositif à puce (400), comprenant au moins un dispositif à circuit intégré (500) selon l'une quelconque des revendications 1 à 5.
